# EUROPÄISCHE PATENTSCHRIFT

(11) **EP 0 943 155 B1**
(45) Veröffentlichungstag und Bekanntmachung des Hinweises auf die Patenterteilung: **27.06.2007**
(21) Anmeldenummer: 98948810.1
(22) Anmeldetag: 19.08.1998
(51) Int. Cl.: H01L 21/3065, H01L 21/308

(54) **VERFAHREN ZUM ANISOTROPEN ÄTZEN VON SILIZIUM**
METHOD FOR ANISOTROPIC ETCHING OF SILICON
PROCEDE POUR L'ATTAQUE ANISOTROPE DU SILICIUM

(30) Priorität: 21.08.1997 DE 19736370
(43) Veröffentlichungstag der Anmeldung: 22.09.1999
(73) Patentinhaber: ROBERT BOSCH GMBH, 70442 Stuttgart (DE)
(72) Erfinder: LÄRMER, Franz, D-70437 Stuttgart (DE); SCHILP, Andrea, D-73525 Schwäbisch Gmünd (DE)
(86) Internationale Anmeldenummer: PCT/DE1998/002406
(87) Internationale Veröffentlichungsnummer: WO 1999/010922

(56) Entgegenhaltungen:
- EP-A- 0 363 982
- EP-A- 0 822 582
- WO-A-94/14187
- DE-A- 4 420 962
- US-A- 4 795 529
- US-A- 5 474 650
- PATENT ABSTRACTS OF JAPAN vol. 012, no. 256 (E-635), 19. Juli 1988 & JP 63 043321 A (MATSUSHITA ELECTRIC IND CO LTD), 24. Februar 1988

## Beschreibung

### Stand der Technik

Die Erfindung betrifft ein Verfahren zum anisotropen Ätzen von Silizium nach dem Oberbegriff des Anspruches 1.

Es ist bekannt, in Siliziumsubstrate, die vorzugsweise in der Halbleitertechnik angewendet werden, definierte Strukturen, beispielsweise Gräben, Kämme, Zungen, Biegebalken oder ähnliches mit geringer bis mittlerer Selektivität anisotrop einzuätzen. Die einzelnen einzuätzenden Strukturen werden üblicherweise durch auf das Siliziumsubstrat aufgebrachte Ätzmasken über sogenannte Maskierschichten, beispielsweise eine Photolackschicht, definiert. Bei der anisotropen Ätztechnik ist es notwendig, zu einer lateral exakt definierten Ausnehmung im Silizium zu kommen. Diese in die Tiefe gehenden Ausnehmungen müssen möglichst genau senkrechte Seitenabschlüsse besitzen. Dabei dürfen die Ränder der Maskierschichten, die diejenigen Siliziumsubstratbereiche abdecken, die nicht geätzt werden sollen, nicht unterätzt werden, um die laterale Genauigkeit der Strukturübertragung von der Maske in das Silizium so hoch wie möglich zu halten. Daraus ergibt sich die Notwendigkeit, die Ätzung nur auf dem Strukturgrund, nicht aber an den bereits erzeugten Seitenwänden der Strukturen fortschreiten zu lassen. In der DE 42 41 045 C1 ist vorgeschlagen worden, das Ätzen von Profilen in Siliziumsubstraten mittels eines Verfahrens, das abwechselnd Plasmapolymerabscheidungs- und Plasmaätzschritte vorsieht, durchzuführen. Dabei werden in einer rein auf Fluorverbindungen aufbauenden Chemie abwechselnd Abscheidungs- und Ätzschritte ausgeführt, wobei während der an sich isotropen Ätzschritte durch ein Vorwärtstreiben des während der vorhergehenden Abscheidungsschritte aufgebrachten Seitenwand-Polymerfilmes die neu freigelegten Teile der Siliziumseitenwand bereits wirksam passiviert werden, so daß der an sich isotrope Ätzschritt lokal hochgradig anisotrop wird. Diese Technik der lokalen Anisotropie durch einen vorwärts getriebenen Seitenwandfilm erlaubt relativ weite Ätzschritte mit sehr hoher Geschwindigkeit, ohne daß die Seitenwand angeätzt wird, die infolgedessen nur eine geringe Rauhigkeit aufweist. Im allgemeinen treten bei der Durchführung dieser Plasmaätzung, wenn sie mit Mikrowellenanregung erfolgt (PIE = propagation ion etching), keine nennenswerte Wandrauhigkeiten auf. Ernste Probleme bereitet dieser Prozeß jedoch auf einer sogenannten induktiv gekoppelten Anlage mit Hochfrequenzanregung des Plasmas (ICP = inductive coupled plasma). Hier kommt es unmittelbar unterhalb des Randes der Photolackmaske im Silizium zur Einätzung einer ausgeprägten Ausnehmung. Diese Ausnehmung ist ein Effekt der induktiven Anregung, die mit magnetischen und elektrischen Feldern im Bereich des Substrates, beispielsweise eines Siliziumwafers, verbunden ist, und tritt auf unterschiedlich aufgebauten ICP-Anlagen in mehr oder weniger starker Ausprägung auf. Induktiv gekoppelte Plasmaanlagen spielen wegen ihrer Robustheit und breiten Einsetzbarkeit eine zunehmend wichtige Rolle und sind an sich gut für den beschriebenen Prozeß geeignet. Bei der Ausbildung der Ätzausnehmungen spielt eine wesentliche Rolle, daß der Übergangsbereich zwischen Photolackmaske und Silizium als Unstetigkeit im Zusammenhang mit elektrischen Feldern der Plasmaquelle einem stärkeren Ionenbombardement ausgesetzt ist als der tieferliegende Teil der Seitenwand. Außerdem wird an der Maskenkante der Mechanismus des vorwärts getriebenen Seitenwandfilms noch nicht voll wirksam. Damit liegt dort eine schwächere Passivierung der Seitenwand vor. Dies führt zu der sogenannten Unterätzung, so daß die eingeätzten Siliziumstrukturen nicht mehr die erforderliche Genauigkeit und kritische Dimensionen aufweisen.

In EP 0 822 582 A2 wird ein Ätzverfahren mit alternierenden Ätz- und Passivierungsschritten für Halbleitersubstrate beschrieben, wobei ein oder mehrere Prozessparameter mit der Zeit variiert werden. Ähnlich ist es aus US 4,795,529 bekannt, während eines Plasmaätzverfahrens mit alternierenden Ätz- und Passivierungsschritten die Beschleunigungsspannung für die Ionen im Plasma zu verändern. In beiden Schriften ist es jedoch nicht vorgesehen, das Ätzverfahren derart zu gestalten, dass die Menge an deponiertem Polymer im Laufe des gesamten Ätzverfahrens mit zunehmender Zahl der Polymerabscheidungsschritte abnimmt.

### Vorteile der Erfindung

Das erfindungsgemäße Verfahren zum anisotropen Ätzen in Silizium vermeidet die Probleme des Unterätzens bei den bisher bekannten ICP-Ätzprozessen dadurch, daß die Menge an deponiertem Polymer im Laufe der Polymerabscheidungsschritte, die alternierend zu den Ätzschritten erfolgen, zu Anfang übergroß ist und dann allmählich abnimmt. Damit wird zu Anfang des Prozesses der Mangel an Seitenwandpolymer durch einen Überschuß an Polymer beseitigt, so daß die Seitenwand genügend passiviert bleibt. Auch das höhere Ionenbombardement an der Unstetigkeitsstelle führt nunmehr nicht zu einer Anätzung des kritischen Bereiches. Es ist daher ein wesentliches Merkmal und ein besonderer Vorteil des Prozesses, daß zuerst mit einem Übermaß an Polymer gearbeitet wird und dieses Übermaß dann anschließend im Laufe der alternierenden Polymer- und Ätzschritte abnimmt. Bisher auftretende Nachteile eines Übermaßes an Polymerabscheidung sind das Auftreten von sogenannten positiv geneigten Profilen, das heißt, die Seitenwand der Ätzgrube ist nicht mehr senkrecht, sondern verengt sich mit zunehmender Ätztiefe, bis eine Spitze entsteht. Eine beispielsweise nur einmalige Korrektur dieses Profils über geeignete Prozeßparameter führt wieder auf das Ausnehmungsproblem an der Unstetigkeitsstelle des Übergangs zurück. Auch dies wird durch die allmähliche Abnahme des deponierten Polymers im Laufe der Polymerabscheidungsschritte vermieden. Der sogenannte anfänglich überfette Prozeß mit einem positiven Profil beginnt ohne Ausnehmungsbildung, so daß man allmählich zu einem Prozeß übergeht, der mit geringerer Polymerabscheidung senkrechte Profile erzeugt und mit diesem den Hauptteil der Ätzung durchführt.

Vorteilhafte Ausgestaltungen und Weiterbildungen des erfindungsgemäßens Verfahrens sind in den Unteransprüchen beschrieben.

In einer besonders vorteilhaften Ausgestaltung des erfindungsgemäßen Verfahrens erfolgt die Anpassung der Polymerabscheidungsschritte stetig von einem Prozeßzyklus zum jeweils nächsten. Man beginnt in vorteilhafter Weise mit einem sogenannten "fetten", das heißt polymerreichen Prozeßparametersatz, der zu einem positiven Profil führen würde, aber Ausnehmungsbildung unter dem Maskenrand sicher vermeidet. Mit jedem der folgenden Zyklen wird nun der Polymeranteil im Prozeß etwas zurückgefahren, so daß bei diesem stetigen Anpassen von verschiedenen Prozeßparametern die Unstetigkeiten in den Profilübergängen und das Ausnehmungsbildungsrisiko minimiert wird. Die Anpassung des Parametersatzes erfolgt in vorteilhafter Weise über die ersten 20 µm Ätztiefe, wenn beispielsweise 100 µm tief in Silizium geätzt werden soll.

In einer weiteren vorteilhaften Weiterbildung des erfindungsgemäßen Verfahrens nimmt die Menge an deponiertem Polymer in diskreten Schritten ab. Man startet beispielsweise mit einer langen Abscheidungszeit pro Schritt, ätzt mit diesem Parametersatz ein gewisses Stück, reduziert dann die Abscheidungszeit, ätzt mit dem neuen Parametersatz eine gewisse Strecke weiter, usw. bis man beim ein senkrechtes Profil erzeugenden Parametersatz angelangt ist.

In vorteilhafter Weise ist es möglich, die Abnahme der Polymermenge durch die Variation der Dauer der Ätzschritte oder der Polymerabscheidungsschritte zu steuern, da bei einer Änderung der Dauer der einzelnen Schritte keine internen Plasmaeigenschaften verändert werden. Die Variation der Dauer des Ätzschrittes oder des Polymerabscheidungsschrittes ist einfach und vom Effekt her überschaubar modifizierbar.

Eine weitere bevorzugte Möglichkeit besteht darin, die Polymermenge durch die Variation der Substrattemperatur zu steuern oder den Druck während der Abscheidung zu ändern. Dabei ist zu beachten, daß beim plötzlichen Übergang von einem ein positives Profil erzeugenden Parametersatz zu einem deutlich weniger positiven ebenfalls die Gefahr der Ausnehmungsbildung auftritt: Das positive Profil ähnelt bei einem Übergang zu einem senkrechten Profil, wenn dies plötzlich erfolgt, von seiner Form her sehr dem Profil des Lackmaskenrandes (oder des SiO₂-Maskenrandes, wenn mit einer Hartstoffmaske gearbeitet wird), und der Übergang zu einer weniger positiven Profilform stellt wieder eine deutliche und signifikante Unstetigkeit in der Seitenwand dar, die bei ICP-Anlagen erneut Anlaß zu Problemen mit Ausnehmungsbildung geben kann. Es ist daher vorteilhaft, diese Anpassung nicht in zu großen Schritten durchzuführen und in mehreren Schritten zu einem vertikalen Parametersatz überzugehen. Insbesondere ist es vorteilhaft, wenn zunächst eine gewisse Strecke mit dem positiven Parametersatz geätzt wird vor dem Übergang zu einem weniger positiven oder vertikalen, da die bereits erzeugte Seitenwand als Polymerdepot wirkt und der Seitenwandfilmtransportmechanismus umso besser funktioniert, je ausgedehnter dieses Polymerdepot bereits ist. In der Praxis kann man beispielsweise in drei Parameterschritten mit je 10 µm Ätzweite diese Anpassung vornehmen, und dann mit einem vertikalen Parametersatz weiterätzen, wenn beispielsweise insgesamt 100 µm tief in Silizium geätzt werden soll.

In einer weiteren besonders vorteilhaften Ausgestaltung des Verfahrens werden sämtliche Parameter stetig angepaßt. Man startet mit einem fetten, das heißt polymerreichen Prozeßparametersatz der zu einem positiven Profil führen würde, aber Ausnehmungsbildung unter dem Maskenrand sicher vermeidet. Mit jedem der folgenden Zyklen wird nun einer der Einflußparameter, beispielsweise die Zeit der Polymerabscheidung, die Dauer der Ätzschritte, die Substrattemperatur oder die Druckvariation in diesem Sinne variiert. Auch bei diesem stetigen Anpassen des gesamten Parametersatzes werden die Unstetigkeiten in den Profilübergängen und damit das Ausnehmungsbildungsrisiko minimiert.

In der Praxis wird in jeder der vorteilhaften Ausgestaltungen des erfindungsgemäßen Verfahrens, obwohl man von einem zunächst positiv geneigten, sich verjüngenden Profil ausgeht und erst allmählich zu einem vertikalen Profil übergeht, insgesamt ein vertikales Ätzprofil erhalten. Dies liegt daran, daß der positive Profilanteil in einem vertikal ätzenden Prozeß nur durch das Seitenwandpolymer, jedoch nicht mehr durch die Maskierung geschützt ist, da das sich verengende positive Profil den Maskenrand in den Graben hinein überragt und die geneigte Seitenwand einem stärkeren Ionenbombardement ausgesetzt ist als eine bereits vertikale Seitenwand. Infolgedessen wird der vertikal ätzende Prozeß das überstehende Teil des Gesamtprofils langsam abtragen und diese Abweichung von der vertikalen Profilform somit selbsttätig korrigieren. Voraussetzung dabei ist nur, daß nach dem Übergang zum vertikalätzenden Prozeßparametersatz, egal ob in diskreten Schritten oder stetig in der beschriebenen Weise, noch eine ausreichend lange Zeit weitergeätzt wird, um diese Profilkorrektur vollständig zu vollziehen. Die angegebenen Werte von 10 bis 20 µm für die Initialisierungsschritte und die anschließenden etwa 80 µm über die mit dem vertikal ätzenden Prozeß geätzt wird, stellen einen groben Anhalt dar für das Prozeßdesign. Selbstverständlich können mit dieser Strategie auch andere, größere Ätztiefen als 100 µm realisiert werden.

Mit dem erfindungsgemäßen Verfahren können beispielsweise isoliert stehende Siliziumstege von nur 1 µm Breite über 40 µm tief geätzt werden, ohne daß Strukturverlust auftritt. Es ist möglich, mit dieser Technik Strukturen herzustellen, die ein Aspektverhältnis, das heißt das Verhältnis von Tiefe zu Strukturbreite von 100: 1 bis 200:1 aufweisen. Die Ätzgeschwindigkeit erreicht dabei Werte von 5 µm/min und mehr, die Maskenselektivität Werte von 100 : 1 (Photolack) oder 200 : 1 (SiO₂). Derartige Strukturen konnten bisher nur mit Hilfe der sogenannten LIGA-Technik (Synchrotonbelichtung in PMMA) aufwendig und extrem teuer hergestellt werden.

### Ausführungsbeispiel

In einer Ätzkammer, oder einem anderen geeigneten Reaktionsbehälter, wird ein entsprechend vorbereitetes Siliziumsubstrat, das heißt ein mit einer Ätzmaske, beispielsweise aus Photolack, beschichtetes Siliziumsubstrat, wobei die Ätzmaske die Bereiche des Siliziumsubstrats freiläßt, die anisotrop eingeätzt werden sollen, einem ersten Polymerabscheidungsschritt ausgesetzt, um an den Maskenrändern ein Polymerdepot anzulegen. Anschließend folgt ein erster Ätzschritt, der bereits von dem angelegten Polymerdepot "zehrt" und so nahezu rein anisotrop ätzt. Für das erfindungsgemäße Verfahren ist es wesentlich, daß der erste Schritt ein Polymerabscheidungsschritt ist, damit der Mechanismus des Seitenwandschutzes während des nachfolgenden Ätzschrittes funktioniert. Anschließend erfolgen abwechselnd weitere Polymerabscheidungs- und Ätzschritte. Das erfindungsgemäße Verfahren kann selbstverständlich auch mit einer analogen, die einzelnen Verfahrensschritte vollziehenden Vorrichtung durchgeführt werden. In diesem Verfahren wird ein Gemisch von beispielsweise SF₆ und Ar eingesetzt, das einen Gasfluß zwischen 0 und 200 Norm cm³ (=SCCM = Standardcm³/min = cm³/min bei 1 bar) und einen Prozeßdruck zwischen 10 und 100 µbar aufweist. Die Plasmaerzeugung erfolgt hierbei vorzugsweise mit einer Mikrowelleneinstrahlung bei Leistungen zwischen 300 und 1200 Watt (2,45 Ghz) oder durch Hochfrequenzeinstrahlung bei Leistungen von 500-2000 Watt in einer ICP-Quelle, die für das erfindungsgemäße Verfahren besonders bevorzugt ist. Gleichzeitig wird an die Substratelektrode eine Substratvorspannung zur Ionenbeschleunigung angelegt. Die Substratvorspannung liegt vorzugsweise zwischen 35 Volt und 70 Volt und kann mit einer Hochfrequenzeinspeisung (13,56 Megaherz) bei Leistungen zwischen 2 und 10 Watt erreicht werden.

Der erste Polymerabscheidungsschritt und natürlich auch die zyklisch darauf folgenden wird mit einem Gemisch aus beispielsweise CHF₃ (Trifluormethan)und Ar durchgeführt. Es ist jedoch in vorteilhafter Weise ebenso möglich, anstelle von Trifluormethan andere fluorhaltige Gase einzusetzen, beispielsweise Octafluorcyclobutan (Freon C 318), Hexafluorpropen (HFP, Fa. Hoechst) oder dessen Dimeres oder auch Tetrafluorethen (TFE). Es ist auch möglich, den Prozess ohne Argon durchzuführen Das Gemisch besitzt einen Gasfluß von vorzugsweise 0 bis 200 Norm cm³ (=SCCM = Standardcm³/min = cm³/min bei 1 bar) und einen Prozeßdruck zwischen 10 und 100 µbar. In einer bevorzugten Ausgestaltung des erfindungsgemäßen Verfahrens wird Octafluorcyclobutan oder Hexafluorpropen eingesetzt, da diese Verbindungen unter ICP-Anregung besonders gute Polymerisationseigenschaften aufweisen. Während des Polymerabscheidungsschrittes werden die freien Flächen, also der Ätzgrund und die Seitenflächen sehr gleichmäßig mit einem Polymer bedeckt. Diese Polymerschicht auf den Kanten bzw. Flächen der Ätzmaske bildet einen sehr wirkungsvollen vorläufigen Ätzschutz. Die auf dem Ätzgrund während des Polymerisationsschrittes aufgebrachte Polymerschicht wird während des darauffolgenden Ätzschrittes rasch durchbrochen, da das Polymer mit Ionenunterstützung sehr schnell abgetragen wird und die chemische Umsetzung der reaktiven Plasmaspezies mit dem Silizium am Ätzgrund voranschreiten kann. Die Seitenwände der einzuätzenden Strukturen bleiben während des Ätzschrittes durch das während des oder der vorhergehenden Polymerabscheidungsschritte aufgebrachte Seitenwandpolymer geschützt.

Während des nunmehr darauf folgenden ersten Ätzschrittes werden in dem Reaktor mit Hilfe einer elektrischen Entladung in dem Gemisch aus SF₆ und Ar chemisch reaktive Spezies und elektrisch geladene Teilchen erzeugt. Die so generierten, positiv geladenen Kationen werden durch die an der Substratelektrode angelegte elektrische Vorspannung zum Siliziumsubstrat hin beschleunigt und fallen annähernd senkrecht auf die durch die Ätzmaske freigelassene Substratoberfläche ein und fördern die chemische Umsetzung der reaktiven Plasmaspezies mit dem Silizium. Darüberhinaus sorgen sie für den Polymerfilmtransport in die Tiefe des Ätzgrabens, wofür speziell derjenige Anteil von Ionen verantwortlich ist, der nicht völlig senkrecht einfällt und auf die Seitenwände auftrifft.Der Ätzschritt kann solange durchgeführt werden, bis die gewünschte Ätztiefe erreicht ist. Daran anschließend erfolgt wieder ein Polymerabscheidungsschritt, bei dem jedoch diesesmal weniger Polymer als beim ersten Male abgeschieden wird. Die Ätzschritte und die Polymerisationsschritte werden so oft alternierend wiederholt, wobei die Prozeßparameter so angepaßt werden, daß die Menge an deponiertem Polymer stetig abnimmt. Diese Prozeßparameter umfassen die nachstehend aufgeführten physikalischen Kenngrößen:
1. Erhöhung der ICP-Leistung, zum Beispiel auf > 1000 Watt, mit gleichzeitiger Erhöhung des Passiviergasflusses, beispielsweise C₄F₈, C₃F₆, (C₃F₆)₂, CHF₃ auf zum Beispiel >200 SCCM (SCCM = Standardcm³/min = cm³/min bei 1 bar), was zu verstärkter Polymerabscheidung führt.
2. Vergrößerung der Zeit für Abscheidungsschritte, was ebenfalls zu verstärkter Polymerabscheidung führt.
3. Verkürzung der Zeit der Ätzschritte, was die Passivierung der Seitenwände effektiv erhöht.
4. Absenkung der Wafertemperatur, was auch die Polymerabscheidung erhöht.
5. Durchführung der Abscheidungsschritte im für ICP-Anlagen günstigsten Druckbereich für die Polymerabscheidung um 10 µbar,
6. Erhöhung des Drucks während der Ätzschritte auf 20 bis 30 µbar, um die Ätzradikalkonzentration zu steigern, aber die das Polymer abtragende Ionenkonzentration zu senken.

Die Abnahme der Polymermenge wird also durch eine Kombination der Polymerabscheidungszeit und/oder Dauer der Ätzschritte und/oder Variation der Substrattemperatur und/oder Variation des Drucks gesteuert.

## Patentansprüche

1. Verfahren zum anisotropen Ätzen von Mikro- und Nanostrukturen in Siliziumsubstraten mittels alternierend aufeinanderfolgender unabhängig gesteuerter Ätz- und Polymerabscheidungsschritte im Plasma, **dadurch gekennzeichnet, dass** der erste Verfahrensschritt ein Polymerabscheidungsschritt ist, bei dem Ätzgrund und Seitenflächen der einzuätzenden Strukturen gleichmäßig mit einem Polymer bedeckt werden und dass die Menge an deponiertem Polymer im Laufe des gesamten Ätzverfahrens mit zunehmender Zahl der Polymerabscheidungsschritte abnimmt.

2. Verfahren nach Anspruch 1, **dadurch gekennzeichnet, dass** die Menge an deponiertem Polymer stetig abnimmt.

3. Verfahren nach Anspruch 1, **dadurch gekennzeichnet, dass** die Menge an deponiertem Polymer in diskreten Schritten abnimmt.

4. Verfahren nach einem der Ansprüche 1 bis 3, **dadurch gekennzeichnet, dass** die Abnahme der Polymermenge durch Verkürzung der Polymerabscheidungszeit gesteuert wird.

5. Verfahren nach einem der Ansprüche 1 bis 3, **dadurch gekennzeichnet, dass** die Abnahme der Polymermenge durch Verlängerung der Dauer der Ätzschritte gesteuert wird.

6. Verfahren nach einem der Ansprüche 1 bis 3, **dadurch gekennzeichnet, dass** die Abnahme der Polymermenge durch Erhöhung der Substrattemperatur gesteuert wird.

7. Verfahren nach einem der Ansprüche 1 bis 3, **dadurch gekennzeichnet, dass** die Abnahme der Polymermenge durch Erniedrigung des Drucks während der Ätzschritte gesteuert wird.

8. Verfahren nach einem der Ansprüche 1 bis 3, **dadurch gekennzeichnet, dass** die Abnahme der Polymermenge durch eine Kombination der Polymerabscheidungszeit und/oder Dauer der Ätzschritte und/oder Variation der Substrattemperatur und/oder Variation des Drucks gesteuert wird.

## Claims

1. Method for anisotropic etching of micro- and nanostructures in silicon substrates by means of alternately successive independently controlled etching and polymer deposition steps in plasma, **characterized in that** the first method step is a polymer deposition step in which etching base and lateral areas of structures to be etched in are uniformly covered with a polymer, and **in that** the quantity of deposited polymer decreases in the course of the entire etching method as the number of polymer deposition steps increases.

2. Method according to Claim 1, **characterized in that** the quantity of deposited polymer decreases continuously.

3. Method according to Claim 1, **characterized in that** the quantity of deposited polymer decreases in discrete steps.

4. Method according to one of Claims 1 to 3, **characterized in that** the decrease in the quantity of polymer is controlled by shortening the polymer deposition time.

5. Method according to one of Claims 1 to 3, **characterized in that** the decrease in the quantity of polymer is controlled by lengthening the duration of the etching steps.

6. Method according to one of Claims 1 to 3, **characterized in that** the decrease in the quantity of polymer is controlled by increasing the substrate temperature.

7. Method according to one of Claims 1 to 3, **characterized in that** the decrease in the quantity of polymer is controlled by lowering the pressure during the etching steps.

8. Method according to one of Claims 1 to 3, **characterized in that** the decrease in the quantity of polymer is controlled by a combination of the polymer deposition time and/or duration of the etching steps and/or variation of the substrate temperature and/or variation of the pressure.

## Revendications

1. Procédé permettant la gravure anisotrope de micro et nanostructures dans des substrats en silicium grâce à l'alternance d'étapes successives de gravure et de dépôt de polymère, commandées de manière indépendante,
**caractérisé en ce que**
la première étape du procédé est une étape de dépôt de polymère dans laquelle le fond de gravure et les faces latérales des structures à graver sont recouverts uniformément d'un polymère, et
la quantité de polymère déposé au cours du procédé de gravure global diminue au fur et à mesure que le nombre des étapes de dépôt de polymère augmente.

2. Procédé selon la revendication 1,
**caractérisé en ce que**
la quantité de polymère déposé diminue de façon continue.

3. Procédé selon la revendication 1,
**caractérisé en ce que**
la quantité de polymère déposé diminue par pas discrets.

4. Procédé selon l'une quelconque des revendications 1 à 3,
**caractérisé en ce que**
la diminution de la quantité de polymère est commandée par le raccourcissement du temps de dépôt de polymère.

5. Procédé selon l'une quelconque des revendications 1 à 3,
**caractérisé en ce que**
la diminution de la quantité de polymère est commandée par le rallongement de la durée des étapes de gravure.

6. Procédé selon l'une quelconque des revendications 1 à 3,
**caractérisé en ce que**
la diminution de la quantité de polymère est commandée par l'augmentation de la température du substrat.

7. Procédé selon l'une quelconque des revendications 1 à 3,
**caractérisé en ce que**
la diminution de la quantité de polymère est commandée par la baisse de la pression pendant les étapes de gravure.

8. Procédé selon l'une quelconque des revendications 1 à 3,
**caractérisé en ce que**
la diminution de la quantité de polymère est commandée par une combinaison du temps de dépôt de polymère et/ou la durée des étapes de gravure et/ou la variation de la température du substrat et/ou la variation de la pression.
